# FASCICULE DE BREVET EUROPEEN

(11) **EP 0 809 255 B1**
(45) Date de publication et mention de la délivrance du brevet: **23.12.1998**
(21) Numéro de dépôt: 97111252.9
(22) Date de dépôt: 12.05.1995
(51) Int. Cl.: G11C 19/00, G06F 11/26

(54) **Cellule pour registre à décalage**
Schieberegisterzelle
Shift register cell

(30) Priorité: 20.05.1994 FR 9406491
(43) Date de publication de la demande: 26.11.1997
(62) Demande divisionnaire de: 95470019.1
(73) Titulaire: SGS-THOMSON MICROELECTRONICS S.A., 94250 Gentilly (FR)
(72) Inventeur: Odinot, Charles, 57000 Metz (FR)
(74) Mandataire: Schmit, Christian Norbert Marie

(56) Documents cités:
- US-A- 4 872 137
- US-A- 4 970 690
- US-A- 5 202 625
- US-A- 5 220 281

## Description

La présente invention concerne une cellule pour registre à décalage. Elle trouve un intérêt tout particulier dans la mise en oeuvre de tests de fonctionnement de circuits intégrés spécialisés.

Les circuits intégrés spécialisés, ou ASIC (de l'anglais "Application Specific Integrated Circuit") sont des circuits intégrés réalisés sur une puce unique à la demande de l'utilisateur. Certains circuits intégrés spécialisés comprennent une unité centrale (par exemple un processeur de traitement de signal, ou DSP, dans le cas d'un circuit intégré dédié au traitement du signal) associée à un certain nombre de dispositifs dépendant de l'application du circuit : mémoires, interfaces...

L'utilisateur fournit au fabricant le programme d'application du circuit et des informations sur la configuration de circuit souhaitée telles que le type et le volume des mémoires ou la nature des dispositifs d'interface du circuit. Le circuit intégré est alors réalisé sur une puce en associant à l'unité centrale les dispositifs spécifiés, notamment une mémoire morte (ROM) contenant le programme d'application.

Pour le test du fabricant, il est connu de faire exécuter par l'unité centrale un programme de test automatique stocké dans la mémoire de programmes du circuit. Comme les configurations dépendent de la demande de l'utilisateur, il n'est pas possible de prévoir un programme de test unique.

Pour tester des circuits intégrés, il est également connu par exemple d'après EP - 0 358 376, d'utiliser un registre à décalage formé en reliant en série un ensemble de cellules élémentaires montées sur les lignes d'entrée/sortie du circuit intégré. Chaque cellule peut injecter sur sa ligne respective une valeur introduite en série à travers le registre à décalage, et échantillonner la valeur du signal véhiculé par cette ligne en vue d'une lecture en série à travers le registre à décalage. On peut ainsi injecter des signaux de test dans le circuit intégré et contrôler le comportement du circuit en réponse à ces signaux.

Un inconvénient de ce système est de ne pas permettre un accès directement aux bus internes du circuit servant aux communications entre l'unité centrale et les dispositifs dépendants de l'application, à moins d'augmenter considérablement le nombre de cellules, ce qui nuit à la compacité du circuit, et à la rapidité du registre à décalage.

Il est également connu, par exemple d'après EP-0 578 540, d'utiliser un registre à décalage formé en reliant des cellules montées sur les lignes d'entrée/sortie de l'unité centrale. Cela permet de tester à la fois l'unité centrale, et les dispositifs associés, avec un nombre de cellules restreint. Elle permet également de tester un grand nombre de configurations possibles sans modifier le registre à décalage.

Typiquement, une cellule utilisée pour prendre place dans un registre à décalage est montée en série sur une ligne (une ligne d'accès à une unité centrale par exemple) et en série avec d'autres cellules connectées à d'autres lignes. Physiquement, la dite ligne sera donc séparée en deux parties. Par exemple, si une telle cellule est montée sur une ligne d'un bus entre une unité centrale et un périphérique, une partie de la ligne ira de l'unité centrale à la cellule, et l'autre partie de la ligne ira de la cellule au périphérique. Une telle cellule comprend donc une entrée, dite parallèle, connectée à une partie de la ligne, une sortie, dite parallèle, connectée à l'autre partie de la ligne (pour injecter sur cette partie de la ligne une valeur transmise de l'extérieur via les autres cellules ou pour fournir la valeur présente sur l'entrée parallèle auquel cas la cellule est transparente), une entrée série, et une sortie série pour permettre de décaler progressivement, dans le registre à décalage dans lequel cette cellule prend place, les valeurs à injecter ou les valeurs échantillonnées.

On voit donc que les cellules pourront être unidirectionnelles si elles sont montées sur des lignes ayant un sens défini de propagation de signal, ou bidirectionnelles si elles sont montées sur des lignes servant à transmettre des signaux dans les deux sens, auquel cas les entrées et sorties parallèles sont en fait des entrée/sortie.

Typiquement, les cellules unidirectionnelles comportent une bascule de mémorisation (par exemple une bascule à retard de type maître-esclave) pouvant recevoir en entrée soit la valeur du signal présent sur l'entrée parallèle (dans le cas d'un échantillonnage), soit sur l'entrée série (dans le cas d'une injection ou d'un décalage), et dont la sortie est connectée à la sortie série (pour permettre le décalage d'une cellule à l'autre). D'autre part, elles comportent aussi classiquement un multiplexeur ayant une entrée connectée à l'entrée parallèle, et une entrée connectée à la sortie de la bascule de mémorisation, éventuellement par le biais d'une bascule à verrouillage, et une sortie connectée à la sortie parallèle, ce multiplexeur permettant d'injecter sur la ligne une valeur, ou de rendre la cellule transparente à la ligne (l'entrée et la sortie parallèles étant alors reliées). Ces différents moyens sont commandés par des signaux de commande provenant soit d'un bloc de contrôle externe, soit d'un bloc de contrôle interne recevant des signaux de commande externes, les procédures de test étant bien sûr pilotés de l'extérieur du circuit.

Dans le cas des cellules bidirectionnelles, la composition des cellules est identique, si ce n'est qu'elles comportent un multiplexeur supplémentaire ayant une entrée connectée à la sortie parallèle (qui se comporte en entrée/sortie), une entrée connectée à la sortie de la bascule de mémorisation (éventuellement par le biais d'une bascule à verrouillage), et une sortie connectée à l'entrée parallèle (qui se comporte en entrée/sortie). D'autre part, il est nécessaire de prévoir une commande et une entrée supplémentaire sur les moyens de multiplexage nécessaires pour pouvoir fournir à l'entrée de la bascule de mémorisation soit la valeur du signal présent à l'entrée série (en cas de décalage) soit la valeur d'un des signaux présents sur les entrée et sortie parallèles (en cas d'échantillonnage).

Les cellules classiquement utilisées présentent plusieurs inconvénients :
- elles induisent des retards dans la propagation d'un signal sur la ligne, de l'ordre de 0,5 à 2 nanosecondes, selon la technologie employée, du fait de la traversée d'au moins un multiplexeur,
- elles posent un problème de synchronisation dans la mesure où les signaux présents sur les lignes dépendent d'horloges internes au circuit, alors que les signaux de commande d'un registre à décalage utilisés pour décaler des valeurs échantillonnées dépendent d'une horloge externe au circuit, puisqu'en pratique, les valeurs à injecter ou les valeurs échantillonnées sont fournies par, ou à des dispositifs de test externes aux circuits à tester. Cela oblige donc soit à produire des signaux de commande de décalage, à partir de signaux externes au circuit, qui soient synchronisés avec les signaux d'horloge internes, soit à arrêter les signaux d'horloge internes de manière à garantir la stabilité des valeurs des signaux présents sur les lignes au moment où ou souhaite les échantillonner. La première solution a l'inconvénient de nécessiter des ressources supplémentaires, et donc d'augmenter la taille et la consommation des circuits, et la deuxième solution a l'inconvénient de nécessiter d'interrompre le fonctionnement du circuit à chaque échantillonnage.
- elles ne garantissent pas l'état logique interne de la cellule, par exemple le signal présent sur la sortie de la bascule de mémorisation où d'éventuelles fuites peuvent éventuellement dégrader ce signal, aucun rebouclage n'étant prévu pour le maintenir,
- elles posent un problème de consommation au niveau de l'entrée des bascules de mémorisation ou à verrouillage, quand celles-ci sont bloquées (entrée isolée de la sortie), car elles sont alors isolées etpeuvent être sujettes à des fuites de type capacitives ou dynamiques au niveau par exemple de substrats de transistors d'entrée.

Au vu de ce qui précède, on peut réaliser une cellule qui n'induise pas de retard sur la ligne à laquelle est connectée.

Il est possible d'avoir une cellule pour registre à décalage, destinée à injecter sur une ligne de transmission une valeur binaire, ou à échantillonner la valeur du signal présent sur la dite ligne, cette cellule comprenant :
- une entrée parallèle connectée à la ligne pour recevoir un signal d'entrée parallèle,
- une sortie parallèle connectée à la ligne pour fournir un signal de sortie parallèle,
- une entrée série pour recevoir un signal d'entrée série à décaler dans une cellule suivante ou à injecter sur la ligne,
- une sortie série pour fournir un signal de sortie série à une entrée série d'une cellule suivante,
caractérisé en ce que l'entrée parallèle et la sortie parallèle sont reliées, la cellule étant montée parallèlement à la ligne de transmission, et en ce que la sortie parallèle est séparée du reste de la cellule par un circuit tampon trois états.

Ainsi, on peut prévoir de réaliser une cellule montée en parallèle sur sa ligne et munie de moyens pour isoler la sortie parallèle de la cellule de manière à ce que le signal présent sur la ligne puisse éventuellement évoluer indépendamment de la cellule.

Un but de l'invention est de proposer une cellule qui ait des capacités de mémorisation, de façon à pouvoir échantillonner la valeur du signal présent sur la ligne sans arrêter le fonctionnement du circuit, et sans obliger à synchroniser les horloges de décalage externes avec les horloges internes du circuit.

Dans une version préférée, la cellule comprendra une bascule à verrouillage ayant une entrée recevant le signal d'entrée parallèle.

Un autre but de l'invention est de proposer une cellule qui permettra de garantir l'état des signaux présents en entrée et en sortie des bascules de la cellule, et par la suite de minimiser la consommation de cette cellule.

Ainsi, l'invention a pour objet le circuit intégré de la revendication 1.

Avantageusement l'entrée de la bascule à verrouillage sera connectée à la sortie d'un multiplexeur, ce multiplexeur ayant une entrée connectée à l'entrée parallèle et une entrée connectée à la sortie de la bascule à verrouillage.

Un autre but de l'invention est de proposer des cellules de type unidirectionnelles ou bidirectionnelles intégrant les capacités de mémorisation et de maintient d'état d'entrée de bascule tels que définies ci dessus.

D'autres particularités et avantages apparaîtront dans la description ci-après, d'exemples de réalisation préférés et non limitatifs, lue conjointement aux dessins annexés, dans lesquels :
- la figure 1 est un schéma d'un circuit intégré mettant en oeuvre un registre à décalage,
- la figure 2 est un schéma d'une cellule montée en parallèle sur une ligne,
- les figures 3, 4, 5, 6 et 7 sont des schémas de cellules montées en série sur des lignes et réalisées conformément à l'invention.

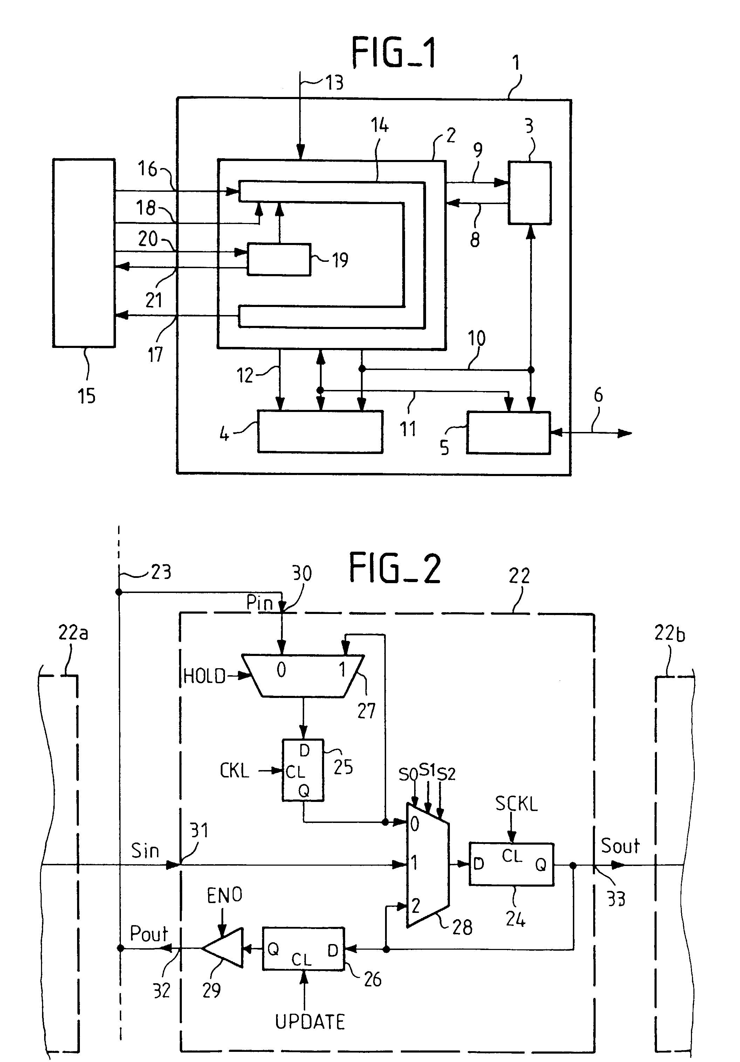

En référence à la figure 1, un circuit intégré 1, réalisé sur une puce de silicium par exemple, comporte une unité centrale 2 et un certain nombre de dispositifs 3, 4, 5 dépendants de l'application du circuit intégré. Les dispositifs associés à l'unité centrale 2 comprennent par exemple une mémoire de programme 3 à lecture seule (ROM), une mémoire de données 4 à accès aléatoire (RAM) et un ou plusieurs dispositifs d'interface schématisés par l'unité 5. Ces dispositifs d'interface sont reliés à des accès primaires 6 du circuit 1 permettant d'échanger des signaux analogiques ou numériques avec l'environnement du circuit 1.

L'unité centrale est reliée à la mémoire de programmes 3 de façon classique, par un bus d'instructions 8, un bus d'adresse d'instructions 9 et des lignes d'un bus de sortie de commandes 10 permettant de lire des instructions de programme dans la mémoire 3 en vue de leur exécution. De même, l'unité centrale 2 est reliée aux dispositifs 4, 5 par un bus de données bidirectionnel 11, un bus d'adresses de données 12 et des lignes du bus de sortie de commandes 10, permettant à l'unité centrale 2 d'échanger des données (émission ou réception) avec les dispositifs 4, 5. L'unité centrale 2 pourra comprendre aussi un bus d'entrée de commande 13 permettant de recevoir des signaux de commande extérieurs.

Dans l'exemple d'application décrit, l'unité centrale 2 est munie d'un registre à décalage 14. Ce registre à décalage 14, du type "boundary scan" (voir EP A 0 358 376), comprend un ensemble de cellules élémentaires reliées en série et montées chacune sur une ligne respective véhiculant un signal binaire du circuit intégré 1. Plus précisément, les cellules sont montées sur des lignes correspondant à des accès à l'unité centrale 2 : bus d'instructions 8, bus d'entrée de commande 13, bus de données 11, bus d'adresses d'instructions 9, etc.

Pour tester le circuit intégré 1, on le relie à un dispositif de test 15. Pour réaliser cette liaison, le circuit 1 comporte :
- une borne 16 qui correspond à l'entrée de données série du registre à décalage 14,
- une borne 17 qui correspond à la sortie de données série du registre à décalage 14,
- des bornes désignées collectivement par la référence 18 pour adresser à l'ensemble des cellules du registre à décalage 14 des signaux de commande,
- des bornes désignées collectivement par la référence 20, pour adresser à une unité de commande 19 des signaux binaires de sélection, et
- des bornes désignées collectivement par la référence 21, pour lesquelles l'unité de commande de test 21 peut adresser des signaux binaires au dispositif de test 15.

On ne décrira pas plus avant le circuit 1, étant donné qu'il schématise un exemple d'utilisation de registre à décalage. on pourra se reporter pour de plus amples détails par exemple à EP 0 578 540 qui décrit en détail une unité centrale telle que décrite ci-dessus.

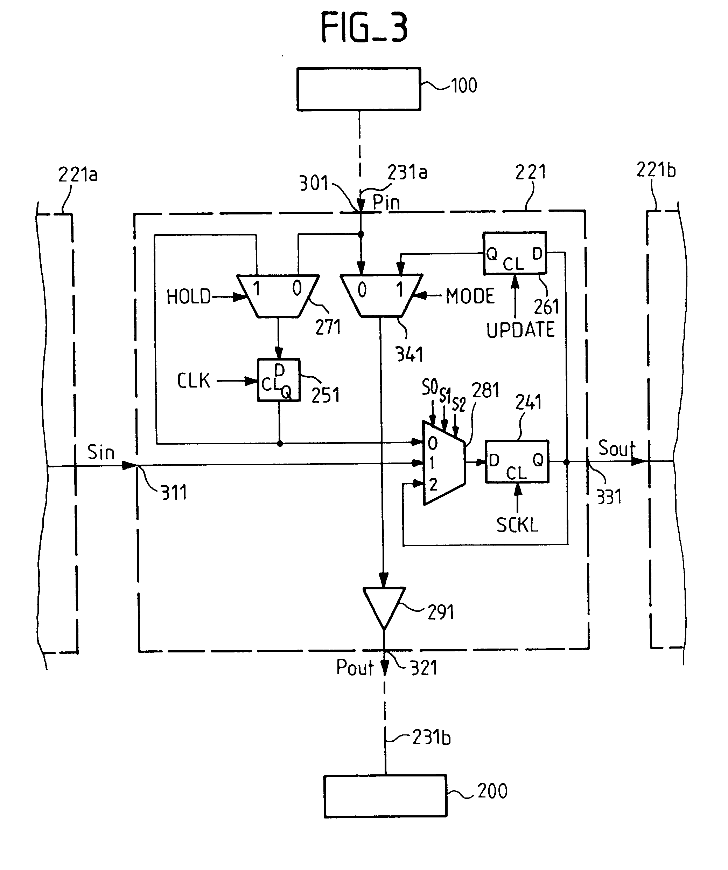

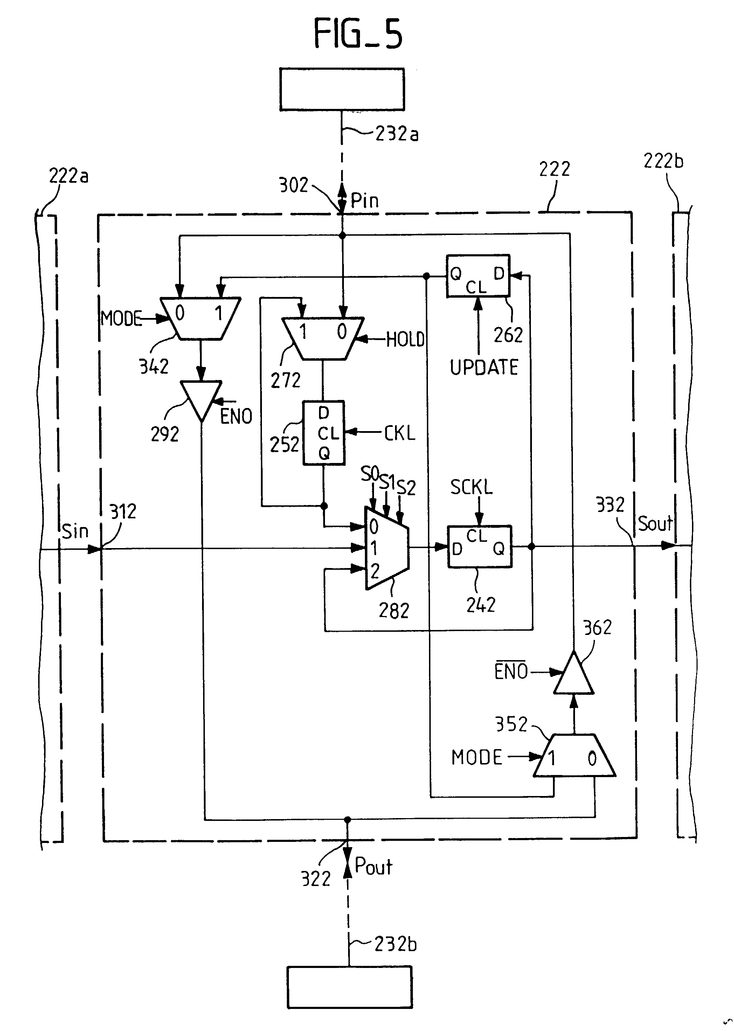

On peut classer les cellules élémentaires d'un registre à décalage en trois types :
- premièrement, des cellules dites de type bus, illustrées par la figure 2, destinées à être reliées à des lignes bidirectionnelles ou unidirectionnelles, telles que celles du bus de données bidirectionnelles 11 ou du bus d'adresse d'instruction 9, et placées en parallèle par rapport à ces lignes,
- deuxièmement, des cellules dites de type unidirectionnel, illustrées par les figures 3 et 5,destinées à être reliées à des lignes unidirectionnelles, telles que celles du bus d'adresses d'instructions 9, et placées en série sur ces lignes,
- troisièmement, des cellules dites de type bidirectionnel, illustrées par les figures, destinées à être reliées à des lignes bidirectionnelles, comme dans le cas des cellules de type bus, mais placées en série sur ces lignes, de manière analogue aux cellules unidirectionnelles.

Les cellules de type unidirectionnel et bidirectionnel sont connues dans leur principe. La cellule de type bus est donnée à titre indicatif.

La figure 2 illustre une cellule de type bus 22, montée en parallèle sur une ligne 23, par exemple une ligne d'accès à l'unité centrale 2. Cette cellule 22 comprend une bascule de mémorisation 24 (par exemple du type à retard maître-esclave), une première bascule à verrouillage 25, une deuxième bascule à verrouillage 26, un premier multiplexeur 27 à deux entrées, un second multiplexeur 28 à trois entrées, et un circuit tampon trois états 29 (en anglais "tristate buffer").

Une entrée parallèle 30 de la cellule 22 reçoit le signal binaire Pin véhiculé par la ligne 23. Cette entrée 30 est reliée à une entrée 0 du premier multiplexeur 27.

Une entrée série 31 reçoit un signal binaire Sin issu de la cellule précédente 22a du registre à décalage 14 ou de la borne 16 d'entrée du registre à décalage 14. Cette entrée série 31 est reliée à une entrée 1 du second multiplexeur 28.

Une sortie parallèle 32 est reliée à la ligne 23 et permet d'injecter une valeur sur cette ligne. On notera Pout le signal présent sur cette sortie parallèle.

Une sortie série 33 est connectée à l'entrée série de la cellule 22b suivante, ou à la borne 17 de sortie du registre 14 si c'est la dernière cellule du registre. On appellera Sout le signal présent sur la sortie série 33.

Le premier multiplexeur 27 a une sortie connectée à l'entrée de la première bascule à verrouillage 25. Cette bascule 25 a sa sortie connectée d'une part à une entrée 0 du second multiplexeur 28 et d'autre part à une deuxième entrée 1 du premier multiplexeur 27.

Le second multiplexeur 28 a une sortie connectée à l'entrée de la bascule de mémorisation 24. Cette bascule 24 a sa sortie connectée à la sortie série 33, à une entrée 2 du second multiplexeur 28 et à l'entrée de la seconde bascule à verrouillage 26.

La seconde bascule à verrouillage 26 a sa sortie connectée à l'entrée du circuit tampon trois états 29, circuit tampon dont la sortie est connectée à la sortie parallèle 32.

Le premier multiplexeur 27 reçoit une commande logique HOLD permettant de relier sélectivement l'entrée de la première bascule à verrouillage 25 à l'entrée parallèle 30, ou à la sortie de cette même bascule. Ainsi, si HOLD = 0, ou pourra échantillonner la valeur du signal Pin présent sur la ligne 23 dans la bascule à verrouillage 25. Si HOLD = 1, on maintiendra les états de l'entrée et de la sortie de cette bascule dans un état stable permanent.

La première bascule à verrouillage 25 reçoit un signal logique de commande CKL de manière à verrouiller, sur sa sortie, la valeur du signal présent à son entrée, sur front descendant de CKL par exemple.

En pratique, les circuits intégrés ont leur fonctionnement synchronisé par un signal d'horloge de base CLOCK, réalisé par exemple à l'aide d'un quartz ou d'un circuit oscillant. Tous les changements d'états logiques sur les lignes (bus de donnée, d'adresse, etc) produits par des dispositifs internes à de tels circuits ne sont susceptibles de se produire que sur des fronts montants ou descendants de ce type d'horloge. De ce fait, on pourra toujours savoir si un changement d'état sur une ligne donnée et produit par un dispositif interne, ne peut se produire que sur front descendant, ou que sur front montant, de ce signal d'horloge de base CLOCK.

Si on souhaite être sûr de la stabilité de la valeur du signal Pin au moment où on la mémorise dans la première bascule à verrouillage 25, il suffira de choisir un signal CKL tel que (dans l'hypothèse d'un verrouillage sur front descendant de CKL) :
- CKL = CLOCK si Pin ne peut changer d'état que sur front montant de CLOCK,
- CKL = /CLOCK si Pin ne peut changer d'état que sur front descendant de CLOCK.

D'autre part, dans le premier (ou second) cas, on choisira un signal HOLD qui passe à 0 par exemple sur front montant (ou descendant) de CLOCK et remonte à 1 sur le front montant (ou descendant) suivant de CLOCK.

Pour permettre un échantillonnage de la valeur du signal Pin, il n'est pas nécessaire que le signal logique CKL oscille lui-même au rythme de l'horloge de base. Il suffit qu'on soit sûr qu'au moment où on souhaite échantillonner, la valeur du signal Pin ne puisse pas changer. On pourra, suivant les lignes, fournir aux cellules des signaux de commande de première bascule de verrouillage qui soient différents et adaptés au type de front sur lequel un changement d'état peut se produire sur ces lignes.

Ce montage a trois avantages :
- on peut échantillonner les valeurs des signaux présents sur les lignes sans arrêter le fonctionnement du circuit pour figer l'état de ces signaux,
- les valeurs échantillonnées sont mémorisées dans la bascule à verrouillage sans risque de dérive, puisque, quel que soit l'état du signal de commande CKL, quand l'entrée de la bascule à verrouillage 25 est isolée de l'entrée parallèle 30 (HOLD = 1), l'entrée et la sortie de la bascule sont dans un même état stable. On peut donc récupérer, par le biais du registre à décalage 14, les valeurs échantillonnées, au moment où on le souhaite, et on évite les risques de consommation accrue du fait des fuites possibles à l'entrée de la bascule à verrouillage 25 puisque son état est stable et non flottant.

Le second multiplexeur 28 reçoit trois signaux de commande logiques S0, S1, S2 pour fournir sélectivement sur la sortie de ce multiplexeur, soit le signal présent en sortie de la première bascule de verrouillage 25, soit le signal présent sur l'entrée série 31, soit le signal présent sur la sortie série 33. On supposera que ces signaux permettent de relier l'entrée qui leur correspond à la sortie s'ils sont à 1, un seul signal étant bien sûr à 1 à la fois.

Ainsi :
- si S0 = 1, alors on pourra transférer la valeur du signal fourni par la première bascule à verrouillage dans la bascule de mémorisation 24 et procéder ainsi au transfert de la valeur échantillonnée sur la ligne 23 dans la cellule suivante 22b,
- si S1 = 1, alors on pourra transférer dans la bascule de mémorisation 24 la valeur d'un signal fourni par la sortie série de la cellule précédente 22a pour la fournir à la cellule suivante (en phase de décalage dans le registre) ou l'injecter sur la ligne 23,
- Si S2 = 1, alors on maintient un état logique stable à l'entrée de la bascule de mémorisation, cet état étant identique à l'état présent sur la sortie de cette bascule. On choisira judicieusement S2 = 1 comme valeur par défaut pour la commande du second multiplexeur 28, quant le registre n'est pas utilisé pour injecter des données ou pour récupérer des données échantillonnées.

De même que dans le cas de la première bascule à verrouillage, on évite ainsi la présence d'un noeud flottant à l'entrée de la bascule de mémorisation, susceptible d'entraîner une consommation due, par exemple, à des fuites de type capacitive au niveau de transistors d'entrée de cette bascule.

La bascule 24 est cadencée par un signal de commande logique SCKL. Typiquement, ce signal sera fourni par le dispositif de test 16 pour contrôler le décalage dans le registre à décalage. Les signaux de commande HOLD et CLK seront plutôt fournis par l'unité de commande 19 dans la mesure où ils doivent être synchrones avec l'horloge de base interne du circuit intégré pour permettre un échantillonnage satisfaisant. De même que pour le signal SCKL, les signaux S0, S1 et S2 seront de préférence fournis par le dispositif de test 16 si on souhaite minimiser la taille de l'unité de commande 19. Si on souhaite par contre minimiser le nombre de broches nécessaires à la communication entre cette unité et le dispositif de test, on choisira avantageusement de les produire de manière interne au circuit.

La seconde bascule à verrouillage 26 reçoit un signal de commande logique UPDATE pour verrouiller sur sa sortie, l'état du signal présent à son entrée, sur front descendant de UPDATE par exemple. De même que pour les autres bascules, l'état de l'entrée de la seconde bascule à verrouillage 26 sera toujours stable, quel que soit l'état du signal de commande UPDATE, si S2 = 1. On évite ainsi d'éventuelles fuites qui seraient possibles si l'état de cette entrée était flottant.

Le circuit tampon trois état 29 reçoit un signal de commande logique ENO. On pourra par exemple réaliser ce circuit en connectant en série deux inverseurs trois états de telle manière que le second soit passant si ENO = 1 et en haute impédance si EN0 = 0. Il est nécessaire d'utiliser un circuit logique trois états pour que le signal présent sur la ligne 23 puisse changer quand on ne souhaite pas injecter sur cette ligne une valeur donnée.Typiquement, le signal de commande ENO pourra être fourni par le dispositif de test 19 de manière à ce qu'il soit synchronisé avec le signal SCKL qui cadence le décalage dans le registre.

La cellule telle que décrite ci-dessus présente donc les avantages suivants :
- elle peut être montée en parallèle sur des lignes aussi bien unidirectionnelles que bidirectionnelles,
- elle n'induit pas de retard de transmission des signaux présents sur la ligne 23,
- elle permet un échantillonnage sans arrêter le fonctionnement du circuit et indépendamment de l'état du signal de commande de décalage SCKL par rapport au signal d'horloge interne CLOCK,
- elle minimise la consommation des cellules en maintenant les entrées des différents bascules dans des états non flottants quand celles-ci sont isolées des entrées de la cellule.

On pourrait bien sûr imaginer des cellules du type bus moins volumineuses, par exemple en :
- se contentant de connecter l'entrée parallèle 30 à l'entrée de la première bascule à verrouillage 25, celle-ci étant commandée par le signal de commande HOLD, évitant ainsi les inconvénients précédents mais en acceptant l'éventualité d'une consommation supplémentaire due à d'éventuelles fuites au niveau des transistors d'entrée de cette bascule quand le signal présent sur la ligne varie,
- se contentant d'un deuxième multiplexeur à deux entrées, en ne rebouclant pas la sortie de la bascule de mémorisation sur son entrée, avec les inconvénients précédemment cités.

La figure 3 représente une cellule de type unidirectionnel 221 de type classique à laquelle on a apporté des modifications conformes à l'esprit de l'invention et faisant référence à la cellule de type bus précédemment décrite.

Cette cellule 221 comprend une entrée parallèle 301, une sortie parallèle 321, une entrée série 311, une sortie série 331, une bascule de mémorisation 241 (par exemple du type à retard maître-esclave), une première bascule à verrouillage 251, une deuxième bascule à verrouillage 261, un premier multiplexeur à deux entrées 271, un second multiplexeur à trois entrées 281, et un circuit tampon 291.

L'entrée parallèle 301 et la sortie parallèle 321 ne sont pas connectées, la ligne 231 étant de fait séparée en deux demi-lignes 231a et 231b, connectées respectivement à des dispositifs du circuit intégré 100 et 200, ces dispositifs étant par exemple une unité centrale et une mémoire, un de ces dispositifs pouvant également être une broche d'entrée/sortie du circuit, etc. Lorsqu'une cellule unidirectionnelle est montée sur une ligne d'entrée de l'unité centrale 2, son entrée parallèle 301 est raccordée à la partie de cette ligne dirigée vers l'extérieur de l'unité centrale 2, et sa sortie parallèle 321 est raccordée à la partie de cette ligne dirigée vers l'intérieur de l'unité centrale 2.

Inversement, lorsqu'une cellule unidirectionnelle est montée sur une ligne de sortie de l'unité centrale 2, son entrée parallèle 301 est raccordée à la partie de cette ligne dirigée vers l'intérieur de l'unité centrale 2, et sa sortie parallèle 321 est raccordée à la partie de cette ligne dirigée vers l'extérieur de l'unité centrale 2.

Ici, on notera 231a la partie de la ligne connectée à l'entrée parallèle 301, et 231b la partie de la ligne connectée à la sortie parallèle 321.

La cellule unidirectionnelle 221 comprend un troisième multiplexeur 341 à deux entrées ayant une entrée 0 connectée à l'entrée parallèle 301, son autre entrée 1 connectée à la sortie de la deuxième bascule à verrouillage 261, et une sortie connectée à l'entrée du circuit tampon 291 dont la sortie est connectée à la sortie parallèle 321. Ce troisième multiplexeur 341 reçoit un signal de commande logique MODE de telle manière que si MODE = 0, alors la cellule est transparente (Pin = Pout), c'est-à-dire que le circuit fonctionne comme si la cellule était absente.

Si MODE = 1, alors la sortie parallèle 321 reçoit la valeur présente en sortie de la deuxième bascule de verrouillage 261 et on peut injecter une valeur sur la partie de la ligne 231b. Typiquement, le circuit de sortie 291 sera composé de deux inverseurs montés en série.

L'entrée parallèle 301 de la cellule 221 est reliée à une entrée 0 du premier multiplexeur 271. L'entrée série 311 reçoit un signal binaire Sin issu d'une cellule précédente 221a du registre à décalage 14 ou de la borne d'entrée 16 du registre à décalage 14. Cette entrée série 311 est reliée à une entrée 1 du second multiplexeur 281. La sortie série 331 est connectée à l'entrée série de la cellule 221b suivante, ou à la borne 17 de sortie du registre 14 si c'est la dernière cellule du registre.

Le premier multiplexeur 271 a une sortie connectée à l'entrée de la première bascule à verrouillage 251. Cette bascule 251 a sa sortie connectée d'une part à une entrée 0 du second multiplexeur 281 et d'autre part à une deuxième entrée 1 du premier multiplexeur 271.

Le second multiplexeur 281 a une sortie connectée à l'entrée de la bascule de mémorisation 241. Cette bascule 241 a sa sortie connectée à la sortie série 331, à une entrée 2 du second multiplexeur 281 et à l'entrée de la seconde bascule à verrouillage 261.

Les signaux de commande nécessaires pour faire fonctionner la cellule sont similaires à ceux utilisés pour la cellule de type bus, si ce n'est que le signal de commande ENO est sans objet dans la cellule 221. On se reportera donc à la description de la cellule de type bus en ce qui les concerne.

Par rapport à la cellule de type bus 22, la cellule monodirectionnelle 221 présente l'inconvénient de retarder la transmission sur la ligne, composée des parties de ligne 231a et 231b, du fait de la présence du troisième multiplexeur 341 et du circuit tampon 291. Par contre, on est sûr que l'on pourra injecter une valeur sur la partie de ligne 231b sans risque de conflit avec un éventuel dispositif pouvant changer l'état du signal sur la partie de ligne 231a, du côté de l'entrée parallèle 301.

En ce qui concerne les éventuelles solutions permettant de diminuer l'encombrement de la cellule, on se reportera à la description de la cellule de type bus.

Le signal de commande MODE sera de préférence fourni par le dispositif de test de façon identique au signal de commande ENO de la cellule de type bus 22, ces deux signaux ayant des buts identiques (commande d'injection d'une valeur sur la ligne ou isolement de la ligne par rapport à la seconde bascule de verrouillage).

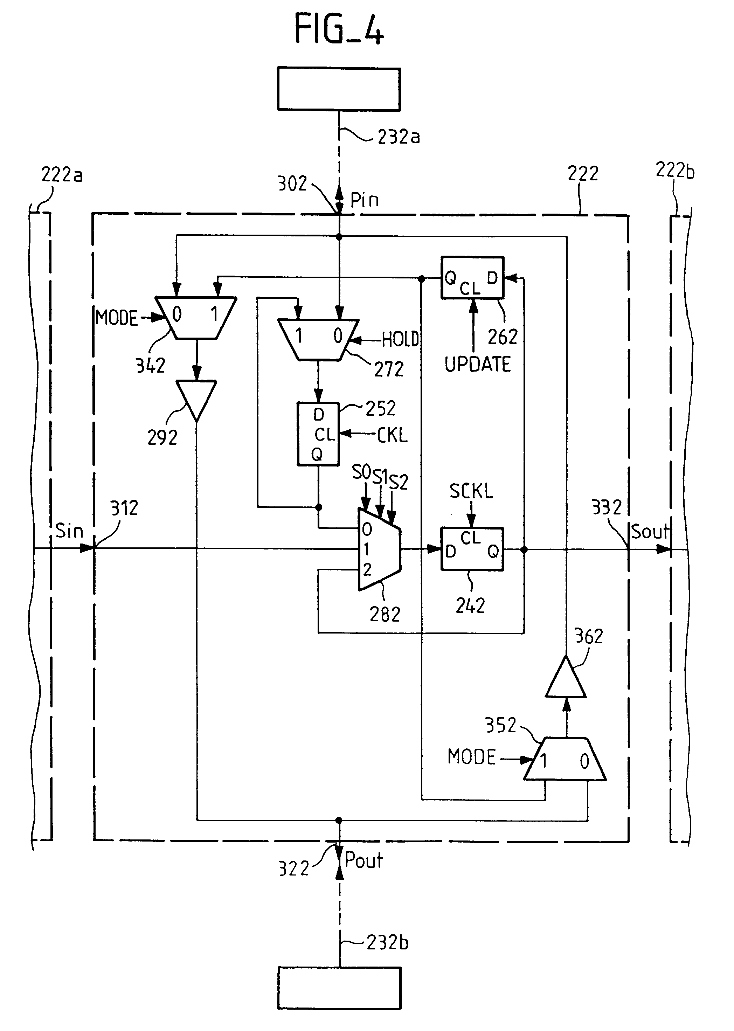

La figure 4 représente une cellule de type bidirectionnelle 222 de type classique à laquelle on a apporté des modifications conformes à celles des solutions envisagées dans la cellule de type bus.

Cette cellule 222 comprend une entrée parallèle 302, une sortie parallèle 322, une entrée série 312, une sortie série 332, une bascule de mémorisation 242 (par exemple du type à retard maître-esclave), une première bascule à verrouillage 252, une deuxième bascule à verrouillage 262, un premier multiplexeur 272 à deux entrées, un second multiplexeur 282 à trois entrées, et un circuit tampon 292.

On note 232a la partie de la ligne connectée à l'entrée parallèle 302, et 232b la partie de la ligne connectée à la sortie parallèle 322.

La cellule bidirectionnelle 222 comprend un troisième multiplexeur 342 à deux entrées ayant une entrée 0 connectée à l'entrée parallèle 302, son autre entrée 1 connectée à la sortie de la deuxième bascule à verrouillage 262, et une sortie connectée à l'entrée du circuit tampon 292 dont la sortie est connectée à la sortie parallèle 322.

L'entrée parallèle 302 de la cellule 222 est reliée à une entrée 0 du premier multiplexeur 272. L'entrée série 312 reçoit un signal binaire Sin issu d'une cellule précédente 222a du registre à décalage 14 ou de la borne d'entrée 16 du registre à décalage 14. Cette entrée série 312 est reliée à une entrée 1 du second multiplexeur 282. La sortie série 332 est connectée à l'entrée série de la cellule 222b suivante, ou à la borne de sortie 17 du registre 14 si c'est la dernière cellule du registre.

Le premier multiplexeur 272 a une sortie connectée à l'entrée de la première bascule à verrouillage 252. Cette bascule 252 a sa sortie connectée d'une part à une entrée 0 du second multiplexeur 282 et d'autre part à une deuxième entrée 1 du premier multiplexeur 272.

Le second multiplexeur 282 a une sortie connectée à l'entrée de la bascule de mémorisation 242. Cette bascule 242 a sa sortie connectée à la sortie série 332, à une entrée 2 du second multiplexeur 282 et à l'entrée de la seconde bascule à verrouillage 262.

Les signaux de commande nécessaires pour faire fonctionner la cellule sont similaires à ceux utilisés pour la cellule de type unidirectionnel. On se reportera donc à la description de cette cellule en ce qui les concerne.

La sortie parallèle 322 est connectée à une entrée d'un quatrième multiplexeur 352 à deux entrées ayant son autre entrée connectée à la sortie de la bascule à verrouillage 262 et une sortie connectée à l'entrée parallèle 302, par le biais d'un second circuit tampon 362 analogue au premier circuit tampon de sortie 292. Ces éléments en plus, par rapport à ceux d'une cellule unidirectionnelle, sont nécessaires pour autoriser une propagation de signal de la sortie parallèle vers l'entrée parallèle.

Une cellule bidirectionnelle telle que définie ci-dessus présente les mêmes avantages et inconvénients que la cellule unidirectionnelle décrite précédemment en ce qui concerne les caractéristiques de mémorisation, de consommation, et de temps de propagation.

On pourrait imaginer de réaliser une cellule bidirectionnelle permettant de réaliser une cellule unidirectionnelle, par exemple pour l'utiliser sur des lignes de port d'entrée/sortie programmable. Une telle cellule est illustrée par la figure 5, qui reprend les références de la figure 4.

Dans la cellule de la figure 5, on utilise des circuits tampon 292 et 362 trois états, commandés par des signaux de commande complémentaires ENO et /ENO, afin qu'un seul circuit tampon soit passant à la fois. Cela présenterait l'avantage d'être certain du sens de propagation du signal. Suivant le sens choisi et programmé, on pourrait produire les signaux de commande adéquats pour ces circuits tampon trois états.

Si on souhaite que le sens de propagation du signal soit de l'entrée parallèle vers la sortie parallèle, il suffit de mettre la sortie du circuit tampon 362 en haute impédance pour retrouver le schéma d'une cellule unidirectionnelle classique. Si au contraire, le sens de propagation souhaité est de la sortie parallèle vers l'entrée parallèle, alors il suffit de mettre le circuit tampon 292 en haute impédance. L'échantillonnage de la valeur du signal présent sur la ligne 232b se fera alors en sortie de cellule (c'est-à-dire au niveau de l'entrée parallèle), ce qui ne change rien, si ce n'est que l'échantillonnage sera plus tardif, la présence du multiplexeur 352 et du circuit tampon 362 induisant un certain délai de propagation du signal.

Un autre avantage d'utiliser des cellules bidirectionnelles à circuit tampon trois états serait de ne proposer qu'un seul type de cellule utilisable pour les lignes à propagation unidirectionnelle sans avoir à se soucier, au moment de leur implantation, du sens de propagation pour orienter la cellule (par contre il faudra connaître ce sens pour produire les signaux de commande ENO et /ENO adéquats). Cela simplifierait également l'implantation dans le sens où toutes les cellules montées en série sur les lignes unidirectionnelles et bidirectionnelles à sens de propagation programmables auraient alors des caractéristiques identiques (taille, consommation, etc.).

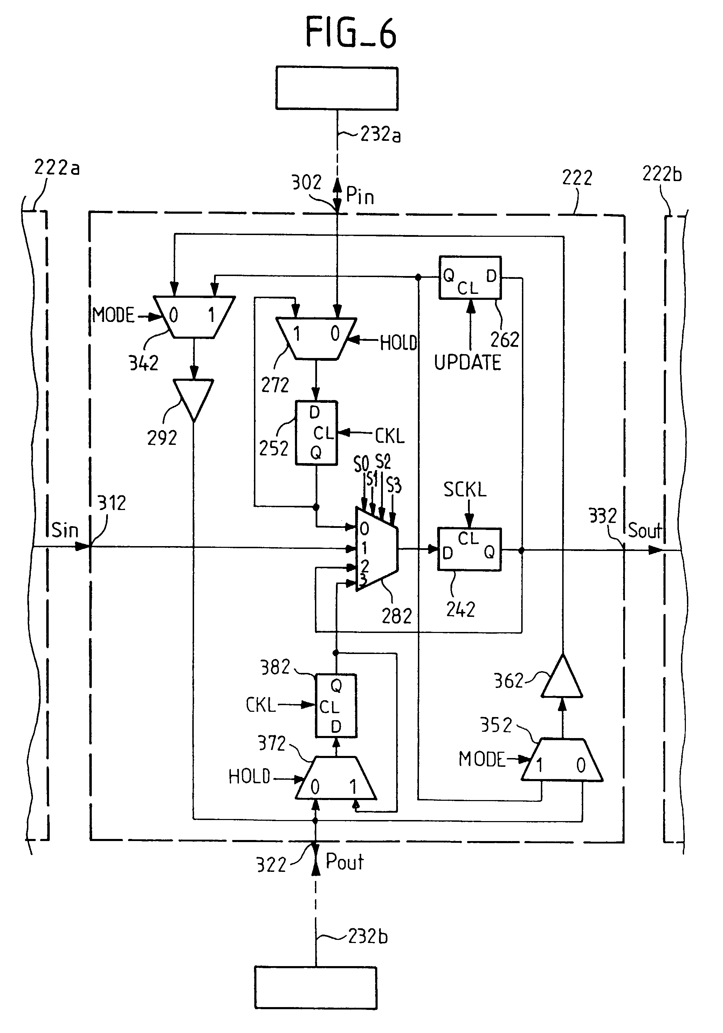

Sur la figure 6, on observe une cellule bidirectionnelle identique à celle de la figure 4 mis à part que la sortie parallèle 322 est également connectée à une entrée d'un cinquième multiplexeur 372 à deux entrées dont la sortie est connectée à l'entrée d'une troisième bascule à verrouillage 382, cette bascule 382 ayant sa sortie connectée à l'autre entrée du cinquième multiplexeur 372.

La sortie de bascule 382 est connectée à une quatrième entrée du multiplexeur 282 et ce multiplexeur reçoit un signal de commande logique supplémentaire S3, fourni par le dispositif de test 19, de manière à pouvoir mémoriser dans la bascule de mémorisation 242 aussi bien la valeur du signal présent sur l'entrée parallèle 302 que celle présente sur la sortie parallèle 322.

Cette cellule de la figure 6 a donc les mêmes fonctionnalités que celle de la figure 4.

Elle rend néanmoins la gestion de la cellule plus complexe puisqu'on doit tenir compte du fait qu'on peut échantillonner aussi bien la valeur du signal présent sur l'entrée parallèle que celle de celui présent sur la sortie parallèle. En principe, ces signaux sont égaux. Néanmoins, on pourrait imaginer souhaiter échantillonner la valeur d'un de ces signaux, en mettant le signal de command HOLD à 0, au moment d'un changement d'un de ces signaux.

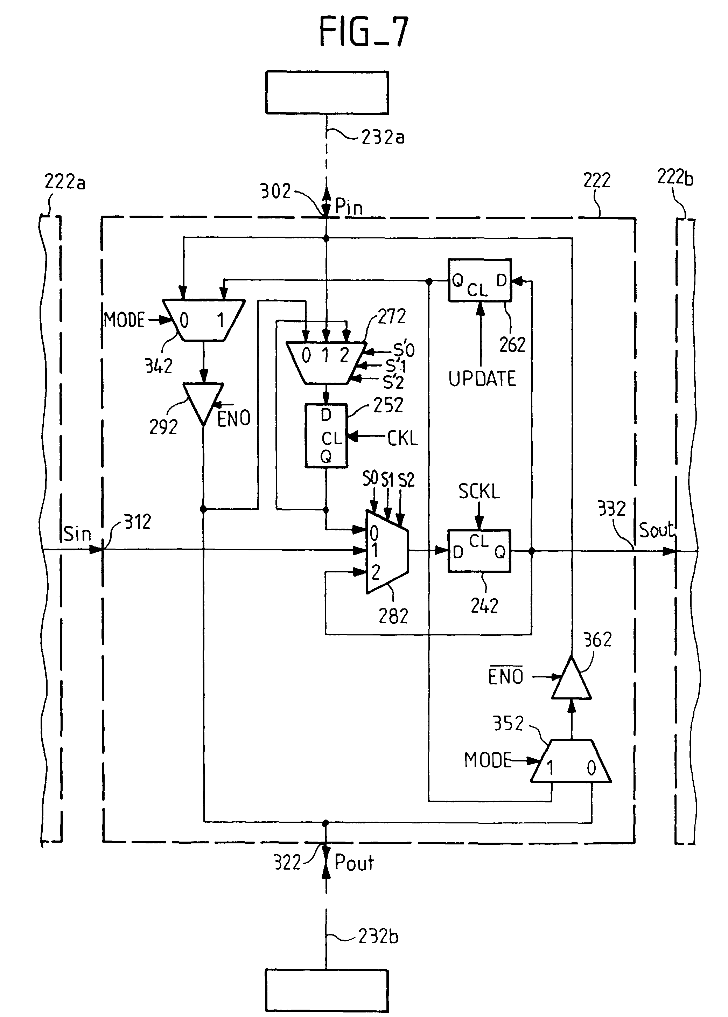

Sur la figure 7, on observe une cellule bidirectionnelle identique à celle de la figure 5 mis à part que le multiplexeur 272 est un multiplexeur à trois entrées. Ce multiplexeur reçoit trois signaux de commande logiques S'0, S'1 et S'2 pour fournir sélectivement sur la sortie de ce multiplexeur, soit le signal présent en sortie du circuit tampon trois états 292, soit le signal présent sur l'entrée parallèle 302, soit le signal présent en sortie de la bascule à verrouillage 252.

Si ces signaux de commande sont tels que S'0 = /HOLD./ENO, S'1 = /HOLD.ENO, et S'2 = HOLD, alors la cellule de la figure 7, par rapport à celle de la figure 5, présente l'avantage d'autoriser la mémorisation dans la bascule à verrouillage 252 de la valeur présente sur une des demi-lignes 232a et 232b alors que l'on injecte une valeur sur l'autre demi-ligne.

Dans la cellule de la figure 5, cela était uniquement possible pour ENO = 1.

Bien qu'on ait décrit l'invention en référence à des exemples de réalisation préférés, on comprendra que ces exemples ne sont pas limitatifs et que diverses modifications peuvent leur être apportées sans sortir du cadre de l'invention. Ainsi, bien qu'on est décrit un exemple de circuit intégré comprenant un registre de décalage formé au niveau des entrées/sorties de l'unité centrale, on pourra très bien utiliser les cellules décrites précédemment pour un circuit intégré dans lequel on forme un registre à décalage sur les entrées/sorties du circuit.

## Revendications

1. Circuit intégré comportant au moins une ligne (231, 232) de transmission entre deux dispositifs (100, 200) et une cellule (221, 222) pour registre à décalage montée en série sur la ligne de transmission (231, 232) entre les deux dispositifs (100,200) pour injecter une valeur binaire sur au moins une partie de la ligne (231b, 232b) connectée à l'un des dispositifs (200), ou à échantillonner la valeur du signal présent sur au moins une partie de la ligne (231a, 232a) connectée à l'un des dispositifs, cette cellule comprenant :
- une entrée parallèle (301, 302) connectée à une partie de la ligne (231a, 232a) connectée à l'un des dispositifs (100) pour recevoir un signal d'entrée parallèle (Pin),
- une sortie parallèle (321, 322) connectée à la partie de la ligne (232b) connectée à l'autre dispositif (200) pour fournir un signal de sortie parallèle (Pout),
- une entrée série (311, 322) pour recevoir un signal d'entrée série (Sin) à décaler dans une cellule suivante (221b, 222b) ou à injecter sur la ligne,
- une sortie série (331, 332) pour fournir un signal de sortie série (Sout) à une entrée série d'une cellule suivante,
- un premier multiplexeur (281, 282) recevant sur une première entrée le signal d'entrée parallèle (Pin) et sur une deuxième entrée le signal d'entrée série (Sin), ce premier multiplexeur (281, 282) ayant une sortie connectée à l'entrée d'une bascule de mémorisation (241, 242),
- un deuxième multiplexeur (341, 342) recevant sur une première entrée le signal d'entrée parallèle (Pin) et sur une deuxième entrée un signal à injecter sur la partie de la ligne (232b) à laquelle est connectée la sortie parallèle (322),
caractérisé en ce que
elle comprend une première bascule à verrouillage (251, 252) recevant sur une entrée le signal d'entrée parallèle (Pin) et ayant une sortie connectée à la première entrée du premier multiplexeur (281, 282), la première bascule à verrouillage (251, 252) recevant également un signal logique de commande (CKL) pour verrouiller, sur sa sortie, le signal présent sur son entrée.

2. Circuit selon la revendication 1, caractérisée en ce que l'entrée parallèle (302) est connectée à une première entrée d'un troisième multiplexeur (272), ce troisième multiplexeur ayant une sortie connectée à l'entrée de la première bascule à verrouillage (252) et une deuxième entrée connectée à la sortie de cette bascule à verrouillage.

3. Circuit selon l'une des revendications 1 à 3, caractérisée en ce que la sortie série (332) est connectée d'une part à la sortie de la bascule de mémorisation (242) et d'autre part à une troisième entrée du premier multiplexeur (282).

4. Circuit selon l'une des revendications 1 à 3, caractérisée en ce qu'elle comprend un quatrième multiplexeur (352) recevant sur une première entrée le signal de sortie parallèle (Pout) et sur une deuxième entrée un signal à injecter sur la partie de la ligne (232a) connectée à l'entrée parallèle (302).

5. Circuit selon la revendication 4, caractérisée en ce que le deuxième multiplexeur (342) est reliée à la sortie parallèle (322) par le biais d'un premier circuit tampon trois états (292), et en ce que le quatrième multiplexeur (352) est relié à l'entrée parallèle (302) par le biais d'un deuxième circuit tampon de sortie trois états (362).

6. Circuit selon la revendication 5, caractérisée en ce qu'une sortie du premier circuit tampon trois états (292) est connectée à une troisième entrée du troisième multiplexeur (272) .

7. Circuit selon l'une des revendications 4 à 6, caractérisé en ce que les deuxièmes entrées du deuxième et du quatrième multiplexeurs (342, 352) sont connectées à une sortie d'une deuxième bascule de verrouillage (262) dont une entrée est connectée à la bascule de mémorisation (242).

8. Circuit selon l'une des revendications 4 à 7, caractérisée en ce qu'elle comprend une troisième bascule à verrouillage (382) qui reçoit sur une entrée le signal de sortie parallèle (Pout), et qui a une sortie connectée à une quatrième entrée du premier multiplexeur (282).

9. Circuit selon la revendication s, caractérisée en ce qu'elle comprend un cinquième multiplexeur (372) ayant une première entrée connectée à la sortie parallèle (322), une deuxième entrée connectée à la sortie de la troisième bascule à verrouillage (382), et une sortie connectée à l'entrée de cette même bascule.

## Patentansprüche

1. Integrierter Schaltkreis mit wenigstens einer Übertragungsleitung (231, 232) zwischen zwei Vorrichtungen (100, 200) und einer Schieberegisterzelle (221, 222), die in der Übertragungsleitung (231, 232) zwischen den zwei Vorrichtungen (100, 200) in Reihe geschaltet ist, um einen binären Wert auf wenigstens einen Leitungsabschnitt (231b, 232b) auszugeben, der mit einer der Vorrichtungen (200) verbunden ist, oder zum Abtasten des Wertes des Signals, das auf wenigstens einem Leitungsabschnitt (231a, 232a) anliegt, der mit einer der Vorrichtungen verbunden ist, wobei diese Zelle umfaßt:
- einen parallelen Eingang (301, 302), der mit einem Leitungsabschnitt (231a, 232a) verbunden ist, welcher mit einer der Vorrichtungen (100) zum Empfangen eines parallelen Eingangssignals (Pin) verbunden ist,
- einen parallelen Ausgang (321, 322), der mit dem Teil der Leitung (232b) verbunden ist, welcher mit der anderen Vorrichtung (200) zum Ausgeben eines parallelen Ausgangssignals (Pout) verbunden ist,
- einen seriellen Eingang (311, 312) zum Empfangen eines seriellen Eingangssignals (Sin), um es in eine folgende Zelle (221b, 222b) zu verschieben oder auf die Leitung auszugeben,
- einen seriellen Ausgang (331, 332) zum Ausgeben eines seriellen Ausgangssignals (Sout) an einen seriellen Eingang einer folgenden Zelle,
- einen ersten Multiplexer (281, 282), der über einen ersten Eingang das parallele Eingangssignal (Pin) und über einen zweiten Eingang das serielle Eingangssignal (Sin) empfängt, wobei dieser erste Multiplexer (281, 282) einen Ausgang hat, der mit dem Eingang eines Speicher-Flip-Flops (241, 242) verbunden ist,
- einen zweiten Multiplexer (341, 342), der über einen ersten Eingang das parallele Eingangssignal (Pin) und über einen zweiten Eingang ein Signal zum Ausgeben auf den Teil der Leitung (232b) empfängt, mit dem der parallele Ausgang (322) verbunden ist,
**dadurch gekennzeichnet,** daß er ein erstes Verriegelungs-Flip-Flop (251, 252) umfaßt, das über einen Eingang das parallele Eingangssignal (Pin) empfängt und das einen Ausgang hat, der mit dem ersten Eingang des ersten Multiplexers (281, 282) verbunden ist, wobei das erste Verriegelungs-Flip-Flop (251, 252) außerdem ein logisches Steuersignal (CLK) empfängt, um über den Ausgang das Signal, das am Eingang anliegt, zu verriegeln.

2. Schaltkreis nach Anspruch 1, dadurch gekennzeichnet, daß der parallele Eingang (302) mit einem ersten Eingang eines dritten Multiplexers (272) verbunden ist, wobei dieser dritte Multiplexer einen Ausgang, der mit dem Eingang des ersten Verriegelungs-Flip-Flops (252) verbunden ist, und einen zweiten Eingang umfaßt, der mit dem Ausgang dieses Verriegelungs-Flip-Flops verbunden ist.

3. Schaltkreis nach einem der Ansprüche 1 oder 2, dadurch gekennzeichnet, daß der serielle Ausgang (332) einerseits mit dem Ausgang des Speicher-Flip-Flops (242) und andererseits mit einem dritten Eingang des ersten Multiplexers (282) verbunden ist.

4. Schaltkreis nach einem der Ansprüche 1 bis 3, dadurch gekennzeichnet, daß er einen vierten Multiplexer (352) umfaßt, der an einem ersten Eingang das parallele Ausgangssignal (Pout) und an einem zweiten Eingang ein Signal zum Ausgeben auf den Teil der Leitung (232a), der mit dem parallelen Eingang (302) verbunden ist, empfängt.

5. Schaltkreis nach Anspruch 4, dadurch gekennzeichnet, daß der zweite Multiplexer (342) mit dem parallelen Ausgang (322) über einen ersten Tristate-Zwischenschaltkreis (292) verbunden ist und daß der vierte Multiplexer (252) mit dem parallelen Eingang (302) über einen zweiten Tristate-Zwischenschaltkreis (362) verbunden ist.

6. Schaltkreis nach Anspruch 5, dadurch gekennzeichnet, daß ein Ausgang des ersten Tristate-Zwischenschaltkreises (292) mit einem dritten Eingang des dritten Multiplexers (272) verbunden ist.

7. Schaltkreis nach einem der Ansprüche 4 bis 6, dadurch gekennzeichnet, daß die zwei Eingänge des zweiten und vierten Multiplexers (342, 352) mit einem Ausgang eines zweiten Verriegelungs-Flip-Flops (262) verbunden sind, deren einer Eingang mit dem Speicher-Flip-Flop (242) verbunden ist.

8. Schaltkreis nach einem der Ansprüche 4 bis 7, dadurch gekennzeichnet, daß er ein drittes Verriegelungs-Flip-Flop (382) umfaßt, das über einen Eingang das parallele Ausgangssignal (Pout) empfängt und das einen Ausgang umfaßt, der mit einem vierten Eingang des ersten Multiplexers (282) verbunden ist.

9. Schaltkreis nach Anspruch 8, dadurch gekennzeichnet, daß er einen fünften Multiplexer (372) mit einem ersten Eingang, der mit dem parallelen Ausgang (322) verbunden ist, einem zweiten Eingang, der mit dem Ausgang des dritten Verriegelungs-Flip-Flops (382) verbunden ist, und mit einem Ausgang, der mit dem Eingang desselben Flip-Flops verbunden ist, umfaßt.

## Claims

1. Integrated circuit having at least one transmission line (231, 232) between two devices (100, 200) and a cell (221, 222) for a shift register connected in series with the transmission line (231, 232) between the two devices (100, 200) in order to inject a binary value on at least part of the line (231b, 232b) connected to one of the devices (200), or to sample the value of the signal present on at least part of the line (231a, 232a) connected to one of the devices, the said cell comprising:
- a parallel input (301, 302) connected to part of the line (231a, 232a) connected to one of the devices (100) in order to receive a parallel input signal (Pin),
- a parallel output (321, 322) connected to the part of the line (232b) connected to the other device (200) in order to supply a parallel output signal (Pout),
- a serial input (311, 312) for receiving a serial input signal (Sin) to be shifted in a following cell (221b, 222b) or to be injected onto the line,
- a serial output (331, 332) for supplying a serial output signal (Sout) at a serial input of a following cell,
- a first multiplexer (281, 282) receiving the parallel input signal (Pin) at a first input and the serial input signal (Sin) at a second input, this first multiplexer (281, 282) having an output connected to the input of a storage flip-flop (241, 242),
- a second multiplexer (341, 342) receiving at a first input the parallel input signal (Pin) and at a second input a signal to be injected onto the part of the line (232b) to which the parallel output (322) is connected,
characterised in that
it comprises a first latching flip-flop (251, 252) receiving the parallel input signal (Pin) at an input and having an output connected to the first input of the first multiplexer (281, 282), the first latching flip-flop (251, 252) also receiving a logic control signal (CKL) for latching, at its output, the signal present at its input.

2. Circuit according to Claim 1, characterised in that the parallel input (302) is connected to a first input of a third multiplexer (272), this third multiplexer having an output connected to the input of the first latching flip-flop (252) and a second input connected to the output of this latching flip-flop.

3. Circuit according to one of Claims 1 to 3, characterised in that the serial output (332) is connected on the one hand to the output of the storage flip-flop (242) and on the other hand to a third input of the first multiplexer (282).

4. Circuit according to one of Claims 1 to 3, characterised in that it comprises a fourth multiplexer (352) receiving at a first input the parallel output signal (Pout) and at a second input a signal to be injected onto the part of the line (232a) connected to the parallel input (302).

5. Circuit according to Claim 4, characterised in that the second multiplexer (342) is connected to the parallel output (322) by means of a first three-state buffer circuit (292), and in that the fourth multiplexer (352) is connected to the parallel input (302) by means of a second three-state output buffer circuit (362) .

6. Circuit according to Claim 5, characterised in that an output of the first three-state buffer circuit (292) is connected to a third input of the third multiplexer (272).

7. Circuit according to one of Claims 4 to 6, characterised in that the second inputs of the second and fourth multiplexers (342, 352) are connected to an output of a second latching flip-flop (262), an input of which is connected to the storage flip-flop (242).

8. Circuit according to one of Claims 4 to 7, characterised in that it comprises a third latching flip-flop (382) which receives the parallel output signal (Pout) at an input and which has an output connected to a fourth input of the first multiplexer (282).

9. Circuit according to Claim 8, characterised in that it comprises a fifth multiplexer (372) having a first input connected to the parallel output (322), a second input connected to the output of the third latching flip-flop (382), and an output connected to the input of this same flip-flop.
